# EUROPÄISCHE PATENTSCHRIFT

(11) **EP 1 645 035 B1**
(45) Veröffentlichungstag und Bekanntmachung des Hinweises auf die Patenterteilung: **27.06.2007**
(21) Anmeldenummer: 04763117.1
(22) Anmeldetag: 07.07.2004
(51) Int. Cl.: H03M 1/68

(54) **DIGITAL-ANALOG-WANDLER UND VERFAHREN ZUR DIGITAL-ANALOG-WANDLUNG**
DIGITAL-ANALOG CONVERTER AND DIGITAL-ANALOG CONVERSION METHOD
CONVERTISSEUR NUMERIQUE-ANALOGIQUE ET PROCEDE DE CONVERSION NUMERIQUE-ANALOGIQUE

(30) Priorität: 11.07.2003 DE 10331545
(43) Veröffentlichungstag der Anmeldung: 12.04.2006
(73) Patentinhaber: Infineon Technologies AG, 81669 München (DE)
(72) Erfinder: KUTTNER, Franz, A-9524 Villach (AT)
(74) Vertreter: Charles, Glyndwr
(86) Internationale Anmeldenummer: PCT/EP2004/007428
(87) Internationale Veröffentlichungsnummer: WO 2005/006560

(56) Entgegenhaltungen:
- US-A- 5 539 405
- US-A- 6 160 507
- US-B1- 6 456 218

## Beschreibung

Die vorliegende Erfindung betrifft einen Digital-Analog-Wandler und ein Verfahren zur Digital-Analog-Wandlung, und insbesondere einen D/A-Wandler mit einer Feldanordnung von Stromzellen unter Einsatz von DEM (Dynamic Element Matching) und ein entsprechendes Wandlungsverfahren.

D/A-Wandler werden heutzutage in vielfältigen Anwendungen eingesetzt. In solchen Applikationen muß stets aus einem digitalen Signal mit Hilfe einer Quantisiereinrichtung ein quantisiertes Analogsignal erzeugt werden. Problematisch dabei ist in aller Regel, daß die Quantisiereinrichtung, welche oft aus einer Vielzahl von Quantisierelementen besteht, keine beliebig hohe Genauigkeit des quantisierten analogen Ausgangssignals gewährleisten kann.

In der US 6,456,218 B1 ist beispielsweise ein D/A-Wandler offenbart, bei dem die als Quantisierungselemente verwendeten Stromquellen durchnummeriert in einer Reihe organisiert sind und derart angesteuert werden, dass bei aufeinanderfolgenden Wandlungszyklen möglichst unterschiedliche Stromquellen angesteuert werden. Dazu ist in der US 6,456,218 B1 eine Dekodiereinrichtung zum Wandeln eines binären Signals in ein Thermometer-Code-Signal vorgesehen und eine gesteuerte Segmentrotationseinrichtung, welche aus dem Thermometer-Code-Signal Ansteuersignale für die Quantisierungselemente bzw. diesen zugeordneten steuerbaren Schaltern ansteuert. Die Stromquellen sind in einer Reihe und entsprechend einer Stelle im Thermometer-Code nummeriert. Dabei ist immer gemäß ihrer Nummerierung eine zusammenhängende Anzahl von Stromquellen eingeschaltet, wobei die Position innerhalb der Reihe von Stromquellen von Wandlungszyklus zu Wandlungszyklus wechselt. Diese Rotation von zusammenhängenden Abschnitten von Quantisierungsstromquellen soll Ungenauigkeiten der Stromquellen untereinander ausgleichen.

Um das Problem ungenauer bzw. unpräziser Quantisierungselemente in D/A-Wandlern zu umgehen, ist es bekannt, DEM (Dynamic Element Matching) einzusetzen, wie in "Design of Multibit Delta-Sigma A/D Converters" von Yves Geerts, Michael Steyaert, Willy Sansen, Kluwer Academic Publisher, ISBN 1-4020-7078-0, auf den Seiten 74 bis 97, beschrieben. Von Nachteil beim Einsatz von DEM ist, daß D/A-Wandler mit einer hohen Auflösung, d.h. mit vielen Quantisierungselementen der Quantisiereinrichtung, dabei eine sehr komplexe Hardware erfordern.

D/A-Wandler mit einer hohen Auflösung werden deshalb bekanntermaßen vorzugsweise als eine Feldanordnung von Stromquellen vorgesehen, wie in der europäischen Patentschrift EP 0 176 981 beschrieben. In Figur 5 ist exemplarisch dargestellt, wie die Stromquellen der einzelnen Zellen 23 der Feldanordnung 22 in einem herkömmlichen D/A-Wandler, gebildet aus einer Stromquellen-Feldanordnung 22, geschaltet werden. Dabei wird beginnend von einer ersten Zelle in der linken oberen Ecke der Feldanordnung 22 entsprechend einem digitalen Eingangssignal eine vorbestimmte Anzahl von Einzelzellen 24 aktiviert, d.h. die Stromquellen in den Einzelzellen eingeschaltet. Die Einzelströme der Stromquellen der Einzelzellen summieren sich ausgangsseitig zu einem Stromsignal eines entsprechenden Pegels. Im wesentlichen läßt sich der Pegel berechnen durch die Anzahl der aktivierten Einzelzellen mal dem Stromwert jeder Einzelzelle, welcher als gleich angenommen wird.

Zum einen tritt dabei der Nachteil auf, daß die Zellen 23 im Anfangsbereich, beginnend mit der ersten Zelle links oben, sehr viel stärker bzw. häufiger beansprucht werden als die Zellen 23 im Endbereich, insbesondere die letzte Zelle 23 der Feldanordnung 22 unten links. Darüber hinaus wirkt sich nachteilig aus, daß jede Einzelzelle 23 in der Praxis keinen exakt identischen Ausgangsstrom, wie beispielsweise die benachbarte aktivierte Zelle 24, liefert. Dadurch entsteht ein Quantisierungsfehler, welcher das quantisierte analoge Stromausgangssignal der Feldanordnung 22 verfälscht bzw. verzerrt. Der Quantisierungsfehler der Anfangszellen 23, beginnend mit der ersten Zelle links oben, fließt dabei wieder und wieder in das Ausgangssignal mit ein.

Es ist deshalb Aufgabe der vorliegenden Erfindung, einen D/A-Wandler bereitzustellen, welcher bei einer großen Auflösung einen kleinen Quantisierungsfehler generiert. Erfindungsgemäß wird diese Aufgabe durch den Digital-Analog-Wandler gemäß Anspruch 1 und durch das Verfahren zur Digital-Analog-Wandlung gemäß Anspruch 9 gelöst.

Die der vorliegenden Erfindung zugrunde liegende Idee besteht im wesentlichen darin, eine DEM-Einrichtung mit einem hochauflösenden D/A-Wandler zu kombinieren, welcher eine Feldanordnung aus Zellen, vorzugsweise mit Stromquellen, aufweist. Dadurch kann die Fläche bzw. ein zusammenhängender Block der Energiequellen, vorzugsweise Stromquellen, welche eingeschaltet sind, an jede Stelle in der Feldanordnung geschaltet werden. Somit kann ein dynamisches Austauschen der Zellen der Feldanordnung und damit der einzelnen in der Regel unpräzisen Energiequellen erfolgen. Außerdem wird demgemäß jede Energiequelle, vorzugsweise Stromquelle, der Zellen in der Feldanordnung gleich häufig eingeschaltet werden, wodurch im wesentlichen eine statistische Streuung der Einzelquantisierungsfehler einer Einzelzelle im Einfluß auf das quantisierte analoge Ausgangssignal erreicht wird.

In der vorliegenden Erfindung wird das eingangs genannte Problem durch einen Digital-Analog-Wandler mit den Merkmalen des Patentanspruch 1 gelöst.

In den Unteransprüchen finden sich vorteilhafte Weiterbildungen und Ausgestaltungen des im Anspruch 1 genannten Digital-Analog-Wandlers.

Gemäß einer bevorzugten Weiterbildung weist die Feldanordnung Einzelzellen mit jeweils einer Stromquelle auf.

Gemäß einer weiteren bevorzugten Weiterbildung weist die DEM-Logikeinrichtung einen Paralleleingang zum Zuführen der digitalen Eingangsdaten auf, welche über eine vorbestimmte Bit-Breite verfügen.

Gemäß einer weiteren bevorzugten Weiterbildung weist die DEM-Logikeinrichtung ausgangsseitig zwei digitale Ausgangsdaten, ein Vorzeichensignal und ein Taktsignal auf, welche an die Decodereinrichtung gekoppelt sind.

Gemäß einer weiteren bevorzugten Weiterbildung weist die Decodereinrichtung ausgangsseitig zwei Zeilenansteuersignale und drei Spaltenansteuersignale und vorzugsweise zwei dazu komplementäre Zeilenansteuersignale und drei komplementäre Spaltenansteuersignale auf, welche zum Aktivieren von Energiequellen vorbestimmter Zellen an die Feldanordnung gekoppelt sind.

Gemäß einer weiteren bevorzugten Weiterbildung weist die Feldanordnung zwei zueinander inverse quantisierte analoge Ausgangssignale auf.

Gemäß einer weiteren bevorzugten Weiterbildung weist die Feldanordnung Einzelzellen mit jeweils einer lokalen Decodereinrichtung auf, welche eingangsseitig jeweils zwei Zeilenansteuersignale und drei Spaltenansteuersignale und vorzugsweise zwei dazu komplementäre Zeilenansteuersignale und drei komplementäre Spaltenansteuersignale aufweist.

Gemäß einer weiteren bevorzugten Weiterbildung weist die Feldanordnung jeweils eine Kantenlänge von mindestens 64 Zellen entsprechend einer Bit-Breite des Eingangssignals von mindestens 12 Bit auf.

Gemäß einer weiteren bevorzugten Weiterbildung werden in der DEM-Einrichtung aus den digitalen Eingangsdaten nach einem vorbestimmten Algorithmus eine Anfangszelle und ein Endzelle in der Feldanordnung bestimmt, zwischen welchen Zellen mit aktivierten Energiequellen liegen, und insbesondere, wenn die aktivierten Zellen die letzte Zelle der Feldanordnung erreichen, werden an der ersten Zelle der Feldanordnung anknüpfend Zellen aktiviert.

Gemäß einer weiteren bevorzugten Weiterbildung wird ein DWA (Data Weighted Averaging)-Algorithmus oder ein bi-DWA (bidirectional Data Weighted Averaging)-Algorithmus oder ein ILA (Individual Level Averaging)-Algorithmus in der DEM-Einrichtung zum Bestimmen der zu aktivierenden Zellen der Feldanordnung eingesetzt.

Gemäß einer weiteren bevorzugten Weiterbildung schaltet eine lokale Decodereinrichtung in einer Zelle der Feldanordnung eine Energiequelle in der Zelle auf einen Ausgang der Decodereinrichtung, wenn ein erstes Spaltensignal und ein erstes Zeilensignal, oder ein zweites Spaltensignal und ein zweites Zeilensignal, oder ein drittes Spaltensignal aktiviert werden.

Ein Ausführungsbeispiel der Erfindung ist in den Zeichnungen dargestellt und in der nachfolgenden Beschreibung näher erläutert.

Es zeigen:
- Fig. 1: ein schematisches Blockdiagramm eines D/A-Wandlers zur Erläuterung einer Ausführungsform der vorliegenden Erfindung;
- Fig. 2: ein schematisches Schaltbild zur Erläuterung eines Details einer Ausführungsform der vorliegenden Erfindung;
- Fig. 3A,B: ein schematisches Diagramm eines Details eines D/A-Wandlers zur Erläuterung der Funktionsweise der vorliegenden Erfindung, wobei die dargestellten Zustände sich im Vorzeichensignal unterscheiden;
- Fig. 4A-D: jeweils ein schematisches Diagramm zur Erläuterung unterschiedlicher Algorithmen; und

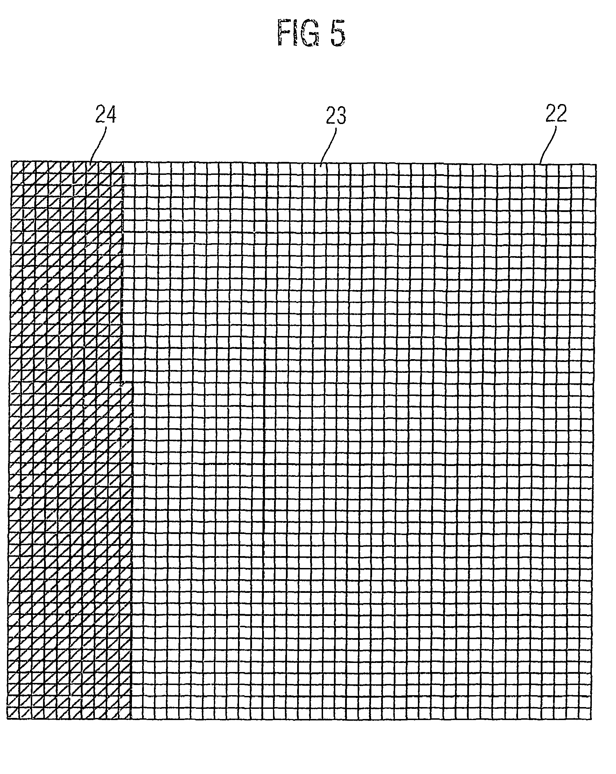

- Fig. 5: eine schematische Zellen-Feldanordnung zur Erläuterung eines Details eines bekannten D/A- Wandlers.

In den Figuren bezeichnen gleiche Bezugszeichen gleiche oder funktionsgleiche Bestandteile.

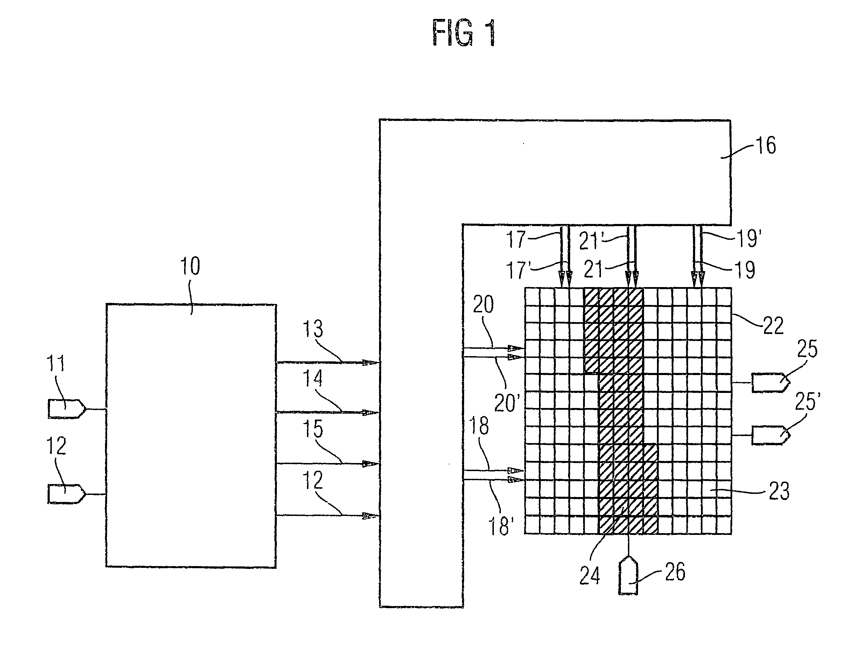

In Fig. 1 ist ein schematisches Blockdiagramm eines erfindungsgemäßen D/A-Wandlers dargestellt, welcher eine DEM-Logikeinrichtung 10 (Dynamic Element Matching) aufweist. Der DEM-Logikeinrichtung 10 werden digitale Daten 11 über einen Eingang zugeführt. Vorzugsweise kommt dabei als Eingang ein Paralleleingang zum Einsatz, welcher z.B. mit zwölf Leitungen bei einer Bit-Breite eines zugeführten digitalen Datums von 12 Bit aufweist. Ein Taktsignal 12 ist ebenfalls an die DEM-Logikeinrichtung 10 gekoppelt. In der DEM-Logikeinrichtung 10 wird auf Basis des am Eingang anliegenden digitalen Signals 11 mit Hilfe eines vorbestimmten im nachfolgenden beschriebenen Algorithmus zwei digitale Ausgangsdaten 13, 14 und ein Vorzeichensignal 15 generiert. Das erste digitale Ausgangssignal 13 der DEM-Logikeinrichtung 10 definiert eine Anfangszelle und das zweite digitale Ausgangssignal 14 definiert eine Endzelle, zwischen denen aktivierte Zellen 24 (nachfolgend beschrieben) liegen. Sowohl das erste digitale Ausgangssignal 13 als auch das zweite digitale Ausgangssignal 14 wird beispielsgemäß jeweils über zwölf Leitungen (Bit-Breite 12 Bit) einer Decodereinrichtung 16 zugeführt. Die Decodereinrichtung 16 empfängt darüber hinaus auch das Taktsignal 12 und das Vorzeichensignal 15 von der Logikeinrichtung 10.

In der Decodereinrichtung 16 werden die zwei digitalen Ausgangssignale 13, 14 der DEM-Logikeinrichtung 10 und das Vorzeichensignal 15 in Ansteuersignale 17, 18, 19, 20, 21 für eine Feldanordnung 22 einzelner Zellen 23 umgewandelt. Die Ansteuersignale 17, 18, 19, 20, 21 gliedern sich vorzugsweise wie folgt, um eine vorbestimmte Anzahl von Zellen 23 der Feldanordnung 22 zu aktivieren. Ein erstes Spaltenansteuersignal 17 legt zusammen mit einem ersten Zeilenansteuersignal 18 fest, ab welcher Zelle 23 der Feldanordnung 22 aktivierte Zellen 24 beginnen sollen. Ein zweites Spaltenansteuersignal 19 und ein zweites Zeilenansteuersignal 20 dient der Festlegung der Anzahl aktivierter Zellen 24 in der letzten Spalte der Feldanordnung 22, welche aktivierte Zellen 24 aufweisen soll, um durch Aktivierung einer vorbestimmten zwischenliegenden Anzahl von Zellen einen quantisierten Ausgangssignalpegel 25 zu generieren. Das Spaltenansteuersignal 21 legt die vollständig aktivierten Spalten der Feldanordnung 22 zur Generierung des quantisierten Ausgangssignals 25 fest.

Gemäß der in Fig. 1 dargestellten Ausführungsform sind neben den Ansteuersignalen 17, 18, 19, 20, 21 auch dazu entsprechend inverse Ansteuersignale 17', 18', 19', 20', 21' vorgesehen. Die Feldanordnung 22 ist vorzugsweise mit einem Referenzstromsignal 26 verbunden, welches den gleichen Pegel wie das maximale Ausgangssignal 25, d.h. alle Zellen der Feldanordnung 22 sind aktivierte Zellen 24, aufweist. Ein zum quantisierten Ausgangssignal 25 die Differenz zum Referenzstrompegel 26 aufweisendes zweites Ausgangssignal 25' ist vorzugsweise zusätzlich vorhanden.

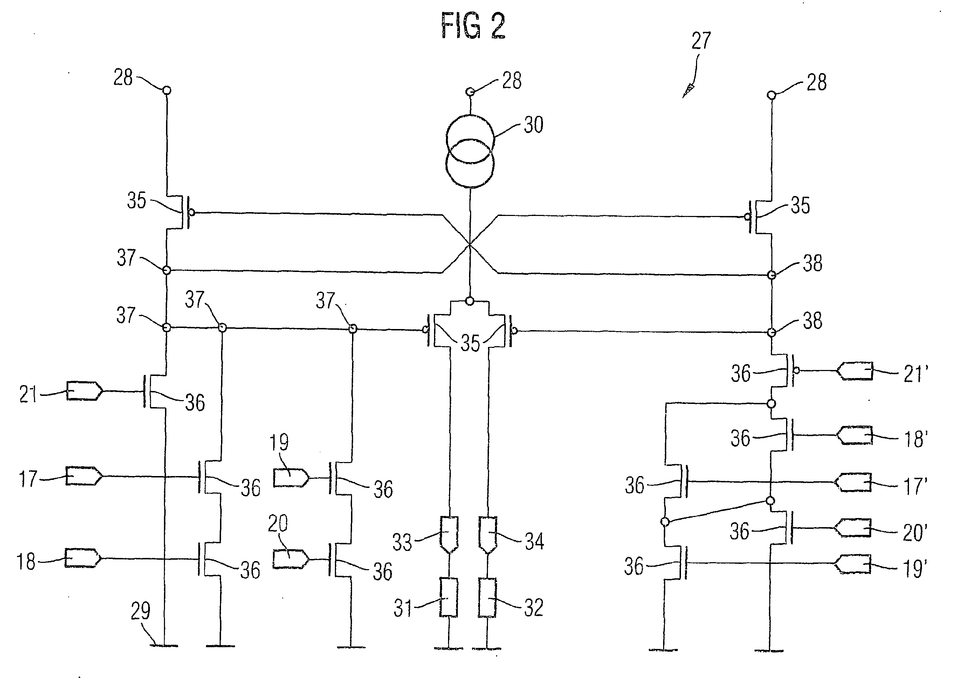

In Fig. 2 ist schematisch ein Schaltbild zur Erläuterung eines exemplarischen Aufbaus einer einzelnen Zelle 23 der Feldanordnung 22 dargestellt. Die mit Bezug auf Figur 2 erläuterte lokale Decodereinrichtung 27 weist eine Potentialquelle 28 auf, welche beispielsweise 2,5 V gegenüber einem Bezugspotential 29 bereitstellt. Eine Stromquelle 30 als exemplarische Energiequelle 30 liefert einen konstanten vorbestimmten Strom, welcher in Abhängigkeit der Ansteuersignale 17, 17', 18, 18', 19, 19', 20, 20', 21, 21' über einen ersten Widerstand 31 oder einen zweiten Widerstand 32 als Strombeitrag 33 des Ausgangssignals 25 gemäß Fig. 1 oder als Strombeitrag 34 des Ausgangssignals 25' fließt. Für die Schaltung der Decodereinrichtung 27 werden vorzugsweise p-Kanal FETs 35 und n-Kanal FETs 36 eingesetzt, welche über die Ansteuersignale 17 bis 21' gate-seitig angesteuert werden.

Die lokale Decodereinrichtung 27 gemäß Fig. 2 repräsentiert exemplarisch die logische Funktion, daß der Strombeitrag 33 durch den ersten Widerstand 31 als Beitrag einer aktivierten Einzelzelle 24 zum Ausgangsstrom 25 gemäß Fig. 1 fließt, wenn entweder das Spaltenansteuersignal 21 oder das erste Spalten- und das erste Zeilenansteuersignal 17, 18 gleichzeitig oder das zweite Spaltensignal 19 und das zweite Zeilensignal 20 gleichzeitig aktiviert sind, d.h. einen high-Pegel aufweisen. Das Ausgangssignal 25 summiert die Strombeiträge 33 der aktivierten Zellen 24. Liegt als Spaltenansteuersignal 21 ein High-Pegel an, so wird das Potential an einem Verknüpfungspunkt 37 auf das Bezugspotential 29 gelegt, wodurch der p-Kanal FET 35 im linken Strang zwischen der Stromquelle 30 und dem ersten Widerstand 31 leitend wird. Dadurch fließt der Strombeitrag 33 im linken Strang. Entsprechendes folgt, wenn ein High-Pegel als Spaltenansteuersignal 17 und gleichzeitig als Zeilenansteuersignal 18 anliegt. Dasselbe Resultat liegt vor, wenn das zweite Spaltenansteuersignal 19 und gleichzeitig das zweite Zeilenansteuersignal 20 einen High-Pegel aufweisen.

Die Ansteuersignale 17 bis 21 und die dazu invertierten Ansteuersignale 17' bis 21' werden eingesetzt, so daß kapazitiv eingekoppelte Störungen von diesen Signalen auf die analogen Strombeiträge 33, 34 bzw. die quantisierten Ausgangsströme 25, 25' gemäß Fig. 1 in erster Näherung eliminiert werden. Mit dem lokalen Decoder 27 gemäß Fig. 2 können höhere Spannungen 28 an den Stromquellen 30 jeder einzelnen Zelle 23 der Feldanordnung 22 gehandhabt werden. Der differentielle Decoder 27 gemäß Fig. 2 kann beispielsweise außerdem mit einem Taktsynchronisationsblock versehen sein (nicht dargestellt).

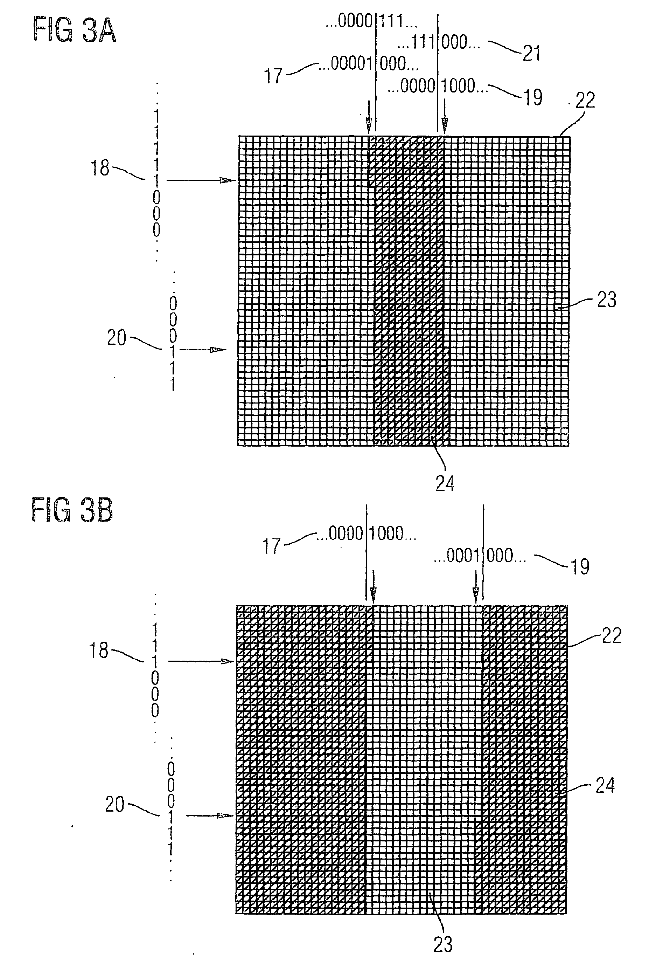

Mit Bezug auf die Fig. 3A und 3B wird schematisch die Ansteuerung von Zellen 23 der Feldanordnung 22 erläutert. Das erste Spaltenansteuersignal 17 ist wie ein Vektor gestaltet, welcher die Länge einer Matrix-Seite der Feldanordnung 22 aufweist. Lediglich in der Spalte, in welcher der Anfangswert der aktivierten Zellen 24 liegt, ist eine Eins vorgesehen, ansonsten Nullen. Entsprechendes gilt für das zweite Spaltenansteuersignal 19, welches als Vektor nur eine Eins in der Spalte aufweist, in welcher die letzte der aktivierten Zellen 24 liegt. Das Spaltensignal 21 wird durch einen Vektor repräsentiert, welcher bei jeder vollständig aktivierten Spalte eine Eins, ansonsten Nullen aufweist.

Das erste Zeilenansteuersignal 18 wird durch einen Vektor repräsentiert, welcher ab der ersten aktivierten Zelle 24 Einsen aufweist, davor mit Nullen versehen ist. Das zweite Zeilenansteuersignal 20 ist ein Vektor, welcher bis zur letzten der aktivierten Zellen 24 eine Eins aufweist, nachfolgend jedoch mit Nullen versehen ist. Auf diese Weise werden an den Zellen 23 der Feldanordnung 22 entsprechende Pegel gemäß Fig. 2 angelegt, wodurch ein Block aktiver Zellen 24 gemäß Fig. 3A generiert wird. Jede aktive Zelle 24 weist einen vorbestimmten Ausgangspegel (gemäß der vorliegenden Ausführungsform einen vorbestimmten Strompegel) auf, und folglich ergibt sich als quantisiertes Ausgangssignal 25 gemäß Fig. 1 ein Stromwert, welcher der Anzahl der aktivierten Zellen 24 mal dem vorbestimmten Strombeitragspegel 33 gemäß Fig. 2 entspricht. In Fig. 3 ist dabei das Vorzeichensignal 15 gemäß Fig. 1 mit einem Low-Pegel, d.h. Null, versehen. Das bedeutet, daß kein Übertrag bzw. eine Fortsetzung eingeschalteter Zellen 24 eines aktivierten Blockes, welcher aktivierte Einzelzellen 24 über die letzte Zelle der Feldanordnung 22 hinaus erfordert und somit gemäß Fig. 3B bei der ersten Zelle der Feldanordnung 22 fortgesetzt wird.

Im Beispiel gemäß Fig. 3B reichen die Zellen, beginnend mit einer aktivierten Zelle im rechten Block aktivierter Zellen 24, nicht aus, um ein Ausgangssignal 25 mit entsprechend hohem Pegel gemäß dem digitalen Eingangssignal 11 nach Fig. 1 bereitzustellen, und so wird der Block beginnend bei der ersten Zelle der Feldanordnung 22 links oben fortgesetzt (linker Block aktivierter Zellen 24 in Fig. 3B). Das Vorzeichensignal weist hierbei einen High-Pegel, d.h. Eins, auf. Derart wird sichergestellt, daß trotz des Setzens bzw. Verschiebens des Blocks aktivierter Zellen 24, einem DEM-Algorithmus folgend, der volle Wiedergabebereich, d.h. die volle Anzahl von Quantisierstufen, d.h. die Zellengesamtanzahl der Feldanordnung 22 (Spalten mal Zeilen) zur Verfügung steht. Gemäß dem vorliegenden Beispiel wird davon ausgegangen, daß die Zelle links oben die erste Zelle der Feldanordnung 22 und die Zelle rechts unten entsprechend die letzte Zelle der Feldanordnung 22 ist.

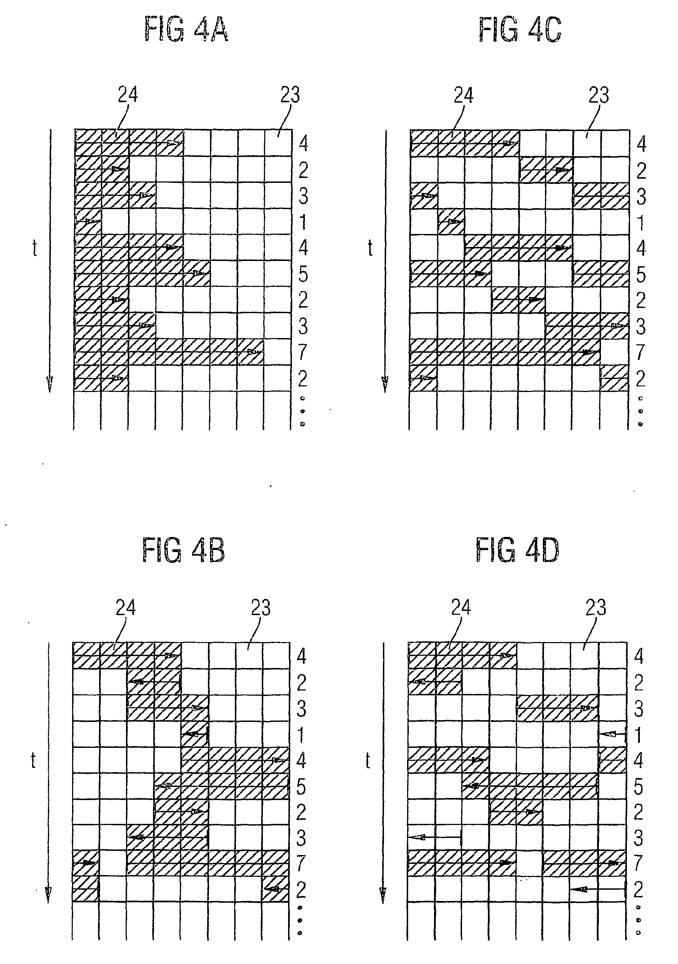

Die Fig. 4A bis 4D zeigen Zeitdiagramme zur Erläuterung verschiedener in der DEM-Logikeinrichtung 10 anwendbarer Algorithmen. Dabei wird pro Zeittakt ein in acht Quantisierungsstufen quantisierbarer Wert wiedergegeben. Es existiert hier zur Wandlung beispielhaft somit lediglich eine Zeile, d.h. jede Zeile zeigt einen neuen Abtastzeitpunkt, im Gegensatz zu Fig. 1 und Fig. 3A,B, in welchen stets ein Abtastzeitpunkt bei einem zweidimensionalen Zellenfeld 22 dargestellt ist.

Gemäß Fig. 4A ist lediglich eine einfache Thermometercodierung ohne DEM dargestellt. Die Zahl hinter einer Zeile steht in allen Abbildungen 4A bis 4D für einen quantisierten Wert. Ohne DEM wird ein Ausgangssignalpegel (Anzahl der schwarz ausgefüllten Kästchen) aus aktivierten Zellen 24 immer mit dem ersten Kästchen auf der linken Seite beginnend dargestellt. Das heißt, das linke Kästchen wird viel häufiger aktiviert als das Kästchen rechts außen.

Im Diagramm gemäß Fig. 4 wird die gleiche Zahlenfolge (4, 2, 3, 1, 4 ,5, 2, 3, 7, 2, ...), wie in Fig. 4A, durch aktivierte Kästchen 24 zu aufeinanderfolgenden Abtastzeitpunkten über der Zeit t dargestellt, wobei eine Codierung gemäß eines ILA-Algorithmus (Individual Level Averaging) eingesetzt wird. Dieser rotatorische Ansatz setzt einen Block aktiver Zellen 24 zu jedem neuen Absatzzeitpunkt, d.h. gemäß der Darstellung in jeder neuen Zeile, in anderer Richtung am Ende des vorherigen Blockes an.

Bei einem DWA-Algorithmus (Data Weighted Averaging) gemäß Figur 4C wird ein neuer Block aktiver Zellen 24 stets in gleicher Richtung am Ende des vorherigen Blocks fortsetzend angehängt. Wird das Ende der Zeile dabei erreicht (hier siehe dritte Zeile), so wird vorne in der Zeile fortsetzend der quantisierte Wert wiedergegeben.

Im Diagramm gemäß Fig. 4D wird exemplarisch ein bi-DWA-Algorithmus (bidirectional Data Weighted Averaging) verdeutlicht, wobei in den ungeraden Zeilen aktivierte Zellen 24 in einer Richtung am Ende des Blockes aktivierter Zellen 24 der vorletzten Zeile anknüpfend die quantisierten Werte wiedergegeben werden. In der zweiten, vierten, sechsten, ... Zeile werden die Blöcke aktivierter Zeilen 24 entsprechend stets in der entgegengesetzten Richtung angehängt.

Diese und weitere Algorithmen sind in der DEM-Logikeinrichtung 10 einsetzbar, um Blöcke aktivierter Zellen 24 auch in einer zweidimensionalen Feldanordnung 22 gemäß Fig. 1 mit jedem neuen Taktsignal am Ende des Blocks aktivierter Zellen des vorherigen Abtastzeitpunktes anzuknüpfen.

Obwohl die vorliegende Erfindung vorstehend anhand bevorzugter Ausführungsbeispiele beschrieben wurde, ist sie darauf nicht beschränkt, sondern auf vielfältige Weise modifizierbar. Obwohl mit Bezug auf eine Eingangs-Bit-Breite von 12 Bit, d.h. 4.096 Quantisierungsstufen, und eine Feldanordnung 22 mit 64 Zeilen und 64 Spalten (in den Fig. 1 und 3 kleiner dargestellt) erläutert, kann die Vorrichtung bzw. das Verfahren auch beliebige kleinere oder größere Feldanordnungen 22 zur quantisierten Umwandlung in ein Analog-Signal einsetzen.

Anstatt Stromquellen als Energiequellen 30 gemäß Fig. 2 einzusetzen, besteht grundsätzlich auch die Möglichkeit, in jeder Zelle eine Spannungsquelle mit vorbestimmter Ausgangsspannung vorzusehen, wobei als Ausgangssignal 25 der Feldanordnung 22 gemäß Fig. 1, insbesondere durch Reihenschaltung der Spannungspegel der aktivierten Einzelzellen 24, das Ausgangssignal 25 generiert wird. Darüber hinaus ist der Aufbau einer Zelle gemäß Fig. 2 mit der Decodereinrichtung 27 beispielhaft und kann unter Bereitstellung der gleichen logischen Funktion auch andersartig ausgeführt werden.

### Bezugszeichenliste

- 10: DEM-Logikeinrichtung (dynamic element matching)
- 11: digitale Eingangsdaten, vorzugsweise parallel mit 12 Bit
- 12: Taktsignal
- 13: digitales Ausgangssignal (Anfangszelle)
- 14: digitales Ausgangssignal (Endelle)
- 15: Vorzeichensignal
- 16: Decodereinrichtung
- 17: erstes Ansteuersignal Spalte
- 17': invertiertes erstes Ansteuersignal Spalte
- 18: erstes Ansteuersignal Zeile
- 18': invertiertes erstes Ansteuersignal Zeile
- 19: zweites Ansteuersignal Spalte
- 19': invertiertes zweites Ansteuersignal Spalte
- 20: zweites Ansteuersignal Zeile
- 20': invertiertes zweites Ansteuersignal Zeile
- 21: Ansteuersignal volle Spalten
- 21': invertiertes Ansteuersignal volle Spalten
- 22: Feldanordnung
- 23: Einzelzelle der Feldanordnung
- 24: aktivierte Zelle
- 25: quantisiertes Ausgangssignal
- 25': invertiertes quantisiertes Ausgangssignal
- 26: Referenzstromsignal
- 27: lokale Decodereinrichtung
- 28: Potentialquelle
- 29: Bezugspotential
- 30: Energiequelle, vorzugsweise Stromquelle
- 31: Widerstand
- 32: Widerstand
- 33: Strombeitrag
- 34: Strombeitrag
- 35: P-Kanal FET
- 36: N-Kanal FET
- 37: Knotenpunkt
- 38: Knotenpunkt

## Patentansprüche

1. Digital-Analog-Wandler mit:
a) einer Feldanordnung (22) mit einer Anzahl von Zellen (23) zwischen einer ersten und einer letzten Zelle zum Ausgeben mindestens eines quantisierten Analogsignals (25, 25'), wobei die Zellen jeweils eine lokale Decodereinrichtung (27) aufweisen, welche eingangsseitg jeweils zwei Zeilenansteuersignale (18, 20) und drei Spaltenansteuersignale (17, 19, 21) aufweist;
b) einer Dynamic-Element-Matching, DEM,-Logikeinrichtung (10) zum Generieren von einem Vorzeichensignal (15) und zwei digitalen Ausgangsdaten (13, 14) aus digitalen Eingangsdaten (11) nach einem vorbestimmten DEM-Algorithmus zum Bestimmen einer Anfangszelle und einer Endzelle in der Feldanordnung (22), zwischen welchen Zellen (24) mit zu aktivierenden Energiequellen (30) liegen, wobei durch das Vorzeichensignal (15) bestimmt ist, ob an die erste Zelle der Feldanordnung (22) anknüpfende Zellen aktiviert werden, falls die zu aktivierenden Zellen (24) die letzte Zelle der Feldanordnung (22) erreichen, und mit
c) einer Decodereinrichtung (16) zum Decodieren der zumindest zwei digitalen Ausgangsdaten (13, 14) und des Vorzeichensignals (15) der DEM-Logikeinrichtung (10) in die zwei Zeilenansteuersignale (18, 20) und drei Spaltenansteuersignale (17, 19, 21), welche zum Aktivieren von Energiequellen (30) der zu aktivierenden Zellen (24) an die Feldanordnung (22) gekoppelt sind.

2. Digital-Analog-Wandler nach Anspruch 1,
**dadurch gekennzeichnet,**
**dass** die Feldanordnung (22) Einzelzellen (23) mit jeweils einer Stromquelle als Energiequelle (30) aufweist.

3. Digital-Analog-Wandler nach Anspruch 1 oder 2,
**dadurch gekennzeichnet,**
**dass** die DEM-Logikeinrichtung (10) einen Paralleleingang zum Zuführen der digitalen Eingangsdaten (11) aufweist, welche über eine vorbestimmte Bit-breite verfügen.

4. Digital-Analog-Wandler nach einem der vorangehenden Ansprüche,
**dadurch gekennzeichnet,**
**dass** die Decodereinrichtung (16) ausgangsseitig ferner zwei komplementäre Zeilenansteuersignale (18', 20') und drei komplementäre Spaltenansteuersignale (17', 19', 21') aufweist, welche zum Aktivieren von Energiequellen (30) vorbestimmter Zellen (24) an die Feldanordnung (22) gekoppelt sind.

5. Digital-Analog-Wandler nach einem der vorangehenden Ansprüche,
**dadurch gekennzeichnet,**
**dass** die Feldanordnung (22) zwei zueinander inverse quantisierte analoge Ausgangssignale (25, 25') aufweist.

6. Digital-Analog-Wandler nach einem der vorangehenden Ansprüche,
**dadurch gekennzeichnet,**
**dass** eine jeweiligen lokale Decodereinrichtung (27) ferner eingangsseitig zwei komplementäre Zeilenansteuersignale (18', 20') und drei komplementäre Spaltenansteuersignale (17', 19', 21') aufweist.

7. Digital-Analog-Wandler nach Anspruch 6
**dadurch gekennzeichnet,**
**dass** die lokale Decodereinrichtung (27) jeweils eine Energiequelle (30) auf einen Widerstand (31) schaltet, wenn ein erstes Spaltensignal (17) und ein erstes Zeilensignal (18), oder ein zweites Spaltensignal (19) und ein zweites Zeilensignal (20), oder ein drittes Spaltensignal (21) aktiviert sind.

8. Digital-Analog-Wandler nach einem der vorangehenden Ansprüche,
**dadurch gekennzeichnet,**
**dass** die Feldanordnung (22) jeweils eine Kantenlänge von mindestens 64 Zellen (23), entsprechend einer Bit-breite des Eingangssignals von mindestens 12 Bit, aufweist.

9. Digital-Analog-Wandler nach einem der vorangehenden Ansprüche,
**dadurch gekennzeichnet,**
**dass** ein Data Weighted Averaging, DWa, -Algorithmus oder ein bidirectional Data Weighted Averaging, bi-DWA, -Algorithmus oder ein Individual Level Averaging, ILA, -Algorithmus in der DEM-Logikeinrichtung (10) zum Bestimmen der zu aktivierenden Zellen (24) der Feldanordnung (22) eingesetzt wird.

## Claims

1. Digital-analogue converter having:
a) an array arrangement (22) having a number of cells (23) between a first and a last cell for outputting at least one quantized analogue signal (25, 25'), the cells each having a local decoder device (27) whose input respectively has two row actuation signals (18, 20) and three column actuation signals (17, 19, 21);
b) a Dynamic Element Matching, DEM, logic device (10) for generating an arithmetic sign signal (15) and two digital output data items (13, 14) from digital input data (11) on the basis of a predetermined DEM algorithm in order to determine an initial cell and a final cell in the array arrangement (22), between which there are situated cells (24) having energy sources (30) which are to be activated, the arithmetic sign signal (15) determining whether cells adjoining the first cell in the array arrangement (22) are activated if the cells (24) to be activated reach the last cell in the array arrangement (22), and having
c) a decoder device (16) for decoding the at least two digital output data items (13, 14) and the arithmetic sign signal (15) from the DEM logic device (10) into the two row actuation signals (18, 20) and three column actuation signals (17, 19, 21), which are coupled to the array arrangement (22) for the purpose of activating energy sources (30) for the cells (24) which are to be activated.

2. Digital-analogue converter according to Claim 1,
**characterized in that**
the array arrangement (22) has single cells (23) with a respective current source as energy source (30).

3. Digital-analogue converter according to Claim 1 or 2,
**characterized in that**
the DEM logic device (10) has a parallel input for supplying the digital input data (11), which have a predetermined bit length.

4. Digital-analogue converter according to one of the preceding claims,
**characterized in that**
the output of the decoder device (16) also has two complementary row actuation signals (18', 20') and three complementary column actuation signals (17', 19', 21') which are coupled to the array arrangement (22) for the purpose of activating energy sources (30) for predetermined cells (24).

5. Digital-analogue converter according to one of the preceding claims,
**characterized in that**
the array arrangement (22) has two mutually inverse quantized analogue output signals (25, 25').

6. Digital-analogue converter according to one of the preceding claims,
**characterized in that**
the input of a respective local decoder device (27) also has two complementary row actuation signals (18', 20') and three complementary column actuation signals (17', 19', 21').

7. Digital-analogue converter according to Claim 6,
**characterized in that**
the local decoder device (27) respectively connects an energy source (30) to a resistor (31) when a first column signal (17) and a first row signal (18), or a second column signal (19) and a second row signal (20), or a third column signal (21), are activated.

8. Digital-analogue converter according to one of the preceding claims,
**characterized in that**
the array arrangement (22) has a respective edge length of at least 64 cells (23), corresponding to a bit length for the input signal of at least 12 bits.

9. Digital-analogue converter according to one of the preceding claims,
**characterized in that**
a Data Weighted Averaging, DWA, algorithm or a bidirectional Data Weighted Averaging, bi-DWA, algorithm or an Individual Level Averaging, ILA, algorithm is used in the DEM logic device (10) in order to determine the cells (24) in the array arrangement (22) which are to be activated.

## Revendications

1. Convertisseur numérique-analogique comprenant :
a) une structure de zone (22) avec un nombre de cellules (23) entre une première et une dernière cellule pour la sortie d'au moins un signal analogique quantifié (25, 25') ; les cellules comprenant à chaque fois un dispositif de décodage local (27) qui comprend, à chaque fois, côté entrée, deux signaux de sélection de ligne (18, 20) et trois signaux de sélection de colonne (17, 19, 21);
b) un dispositif logique DEM Dynamic-Element-Matching (10) pour générer un signal de signe (15) et deux données de sortie numériques (13, 14), à partir de données d'entrée numérique (11), selon un algorithme DEM prédéfini pour déterminer, dans la structure de zone (22), une cellule initiale et une cellule finale entre lesquelles se trouvent des cellules (24) avec des sources d'énergie (30) à activer, le signal de signe (15) déterminant si des cellules qui sont rattachées à la première cellule de la structure de zone (22) sont activées au cas où les cellules à activer (24) atteignent la dernière cellule de la structure de zone (22), et comprenant
c) un dispositif de décodage (16) pour le décodage des au moins deux données de sortie (13, 14) numériques et du signal de signe (15) du dispositif logique DEM (10) pour obtenir les deux signaux de sélection de ligne (18, 19) et les trois signaux de sélection de colonnes (17, 19, 21), lesquels sont connectés à la structure de zone (22) pour activer des sources d'énergie (30) des cellules à activer (24).

2. Convertisseur numérique-analogique selon la revendication 1,
**caractérisé en ce que**
la structure de zone (22) comprend des cellules individuelles (23) avec, à chaque fois, une source de courant comme source d'énergie (30).

3. Convertisseur numérique-analogique selon la revendication 1 ou 2,
**caractérisé en ce que**
le dispositif logique DEM (10) comprend une entrée parallèle pour entrer les données d'entrée numériques (11), lesquelles disposent d'une largeur de bit prédéfinie.

4. Convertisseur numérique-analogique selon l'une quelconque des revendications précédentes,
**caractérisé en ce que**
le dispositif de décodage (16) comprend, de plus, côté sortie, deux signaux de sélection de ligne complémentaires (18', 20') et trois signaux de sélection de colonne complémentaires (17', 19', 21'), lesquels sont connectés à la structure de zone (22) pour activer des sources d'énergie (30) de cellules prédéterminées (24).

5. Convertisseur numérique-analogique selon l'une quelconque des revendications précédentes,
**caractérisé en ce que**
la structure de zone (22) comprend deux signaux de sortie analogiques quantifiés et inversés l'un par rapport à l'autre (25, 25').

6. Convertisseur numérique-analogique selon l'une quelconque des revendications précédentes,
**caractérisé en ce que**
un dispositif de décodage local correspondant (27) comprend de plus, côté entrée, deux signaux de sélection de ligne complémentaires (18', 20') et trois signaux de sélection de colonne complémentaires (17', 19', 21').

7. Convertisseur numérique-analogique selon la revendication 6,
**caractérisé en ce que**
à chaque fois, le dispositif de décodage local (27) connecte une source d'énergie (30) avec une résistance (31) lorsqu'un premier signal de colonne (17) et un premier signal de ligne (18), ou un deuxième signal de colonne (19) et un deuxième signal de ligne (20), ou un troisième signal de colonne (21) sont activés

8. Convertisseur numérique-analogique selon l'une quelconque des revendications précédentes,
**caractérisé en ce que**
la structure de zone (22) comprend, à chaque fois, une longueur d'arête d'au moins 64 cellules (23), correspondant à une largeur de bit du signal d'entrée d'au moins 12 bits.

9. Convertisseur numérique-analogique selon l'une quelconque des revendications précédentes,
**caractérisé en ce qu'**
un algorithme Data Weighted Averaging, DWA, ou un algorithme Data Weighted Averaging bidirectionnel, bi-DWA, ou un algorithme Individual Level Averaging, ILA, est utilisé dans le dispositif logique DEM (10) pour déterminer les cellules à activer (24) de la structure de zone (22).
